(19) Europäisches Patentamt
European Patent Office
Office européen des brevets

(11) **EP 4 262 051 A1**

(12) **EUROPEAN PATENT APPLICATION**
published in accordance with Art. 153(4) EPC

(43) Date of publication:
**18.10.2023 Bulletin 2023/42**

(21) Application number: **22749978.7**

(22) Date of filing: **28.01.2022**

(51) International Patent Classification (IPC):
**H02J 50/12** (2016.01)   **H01F 38/14** (2006.01)
**H03H 7/38** (2006.01)   **H01F 5/02** (2006.01)

(52) Cooperative Patent Classification (CPC):
**H01F 5/02; H01F 38/14; H02J 50/12; H03H 7/38**

(86) International application number:
**PCT/KR2022/001593**

(87) International publication number:
**WO 2022/169228 (11.08.2022 Gazette 2022/32)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **04.02.2021 KR 20210016327**

(71) Applicant: **Samsung Electronics Co., Ltd.
Suwon-si, Gyeonggi-do 16677 (KR)**

(72) Inventors:
• **GU, Beomwoo**
  **Suwon-si, Gyeonggi-do 16677 (KR)**
• **PARK, Jaehyun**
  **Suwon-si, Gyeonggi-do 16677 (KR)**
• **CHOI, Bohwan**
  **Suwon-si, Gyeonggi-do 16677 (KR)**

(74) Representative: **Gulde & Partner
Patent- und Rechtsanwaltskanzlei mbB
Wallstraße 58/59
10179 Berlin (DE)**

(54) **WIRELESS POWER RECEIVER COMPRISING PLURALITY OF COILS**

(57)    The present disclosure provides a wireless power receiver. The wireless power receiver of the present disclosure may comprise: a resonant circuit which comprises a coil having a plurality of turns and receives power transmitted from a wireless power transmitter; an auxiliary receiving coil which forms a tab at a first point of the innermost turn from among the plurality of turns of the coil, comprises part of the innermost turn of the coil to form a loop, and is inductively coupled to the coil; and a reception circuit unit which is electrically connected to the auxiliary receiving coil and processes power induced in the auxiliary receiving coil on the basis of the power received by the resonant circuit. According to the wireless power receiver of the present disclosure, various other embodiments are applicable.

FIG. 3

EP 4 262 051 A1

**Description**

[Technical Field]

Various embodiments of the disclosure relate to a wireless power receiver including a plurality of coils.

[Background Art]

With the development of a wireless charging technology, a charging method of supplying power to various electronic devices (wireless power receiver) from one charging device (wireless power transmitter) is being researched. An electromagnetic induction scheme of using a coil, a resonance scheme of using a resonance, and a radio wave emission (RF/microwave radiation) scheme of switching an electric energy into a microwave and transmitting same are provided for a wireless charging technology.

For example, a wireless charging technology using an electromagnetic induction scheme or a resonance scheme for an electronic device, such as a smart phone, has been disseminated. When a wireless power transmitter (power transmitting unit, PTU) (for example, wireless charging pad) and a wireless power receiver (power receiving unit, PRU) (for example, smart phone or electronic device) come into contact with each other or are approached to a predetermined distance, a battery of a wireless power receiver (e.g., electronic device) may be charged by a method of an electromagnetic resonance or an electromagnetic induction between a receiving coil of a wireless power receiver and a transmitting coil of a wireless power transmitter.

[Detailed Description of the Invention]

[Technical Problem]

A wireless power receiver may include a plurality of coils in a receiving unit. For example, the wireless power receiver may include a plurality of coils (for example, a coil (e.g., resonance coil) included in a resonance circuit) magnetically coupled to configure a parallel resonance in the receiving unit which wirelessly receives power and an auxiliary reception coil.

In case that a plurality of coils are mounted in a housing of a wireless power receiver, an area for configuring a multi-coil by the plurality of coils may be limited, and the thickness of the wireless power receiver may increase as a layer increases when the plurality of coils are arranged. In addition, in case that a coil pattern of the wireless power receiver is added, the manufacturing cost of a flexible printed circuit board (FPCB) may increase.

In various embodiments of the disclosure, in case that a receiving unit of a wireless power receiver is configured by a plurality of coils, a wireless power receiver may share a part of a coil (e.g., resonance coil) included in a resonance circuit with an auxiliary reception coil, so that the volume and the manufacturing cost of the wireless power receiver may be reduced.

[Technical Solution]

In order to resolve the foregoing problem or other problems, a wireless power receiver according to an embodiment may include a resonance circuit including a coil having a plurality of turns and receiving power transmitted from a wireless power transmitter, an auxiliary reception coil inductively coupled to the coil and configured to establish a tap at a first point of the innermost turn among a plurality of turns of the coil to establish a loop including a part of the innermost turn of the coil, and a reception circuit unit electrically connected to the auxiliary reception coil and configured to process power induced into the auxiliary reception coil based on power received by the resonance circuit.

A wireless power receiver according to one of various embodiments may include a resonance circuit including a coil having a plurality of turns and receiving power transmitted from a wireless power transmitter, and an auxiliary reception coil configuring a tap at a first point of the innermost turn among a plurality of turns of the coil, to configure a loop while including a part of the innermost turn of the coil, and inductively coupled to the coil.

A wireless power receiver according to one of various embodiments may include a resonance circuit including a coil having a plurality of turns and receiving power transmitted from a wireless power transmitter, an auxiliary reception coil inductively coupled to the coil and configured to establish a tap at a first point of the innermost turn among a plurality of turns of the coil to be connected to the coil and to establish at least one turn in the innermost turn of the coil, and a reception circuit unit electrically connected to the auxiliary reception coil and configured to process power induced into the auxiliary reception coil based on power received by the resonance circuit.

[Advantageous Effects]

A wireless power receiver according to various embodiments may share a part of a coil included in a resonance circuit with an auxiliary reception coil when a receiving unit of a wireless power receiver is configured by a plurality of coils, so that the volume and the manufacturing cost of the wireless power receiver may be reduced.

[Brief Description of Drawings]

FIG. 1A is a circuit diagram of a wireless power transmitter and a wireless power receiver according to various embodiments of the disclosure.

FIG. 1B is a view illustrating a coil structure of a wireless power receiver according to various embodiments of the disclosure.

FIG. 1C is a circuit diagram of a wireless power receiver according to various embodiments of the disclosure.

FIG. 2A is a graph illustrating a relationship between load impedance and a voltage gain according to various embodiments of the disclosure.

FIG. 2B is a graph illustrating a relationship between load impedance and output power according to various embodiments of the disclosure.

FIG. 3 is a view illustrating a coil structure of a wireless power receiver according to various embodiments of the disclosure.

FIG. 4 is a circuit diagram of a wireless power receiver according to various embodiments of the disclosure.

FIG. 5 is a view illustrating a coil structure of a wireless power receiver according to various embodiments of the disclosure.

FIG. 6 is a view illustrating a coil structure of a wireless power receiver according to various embodiments of the disclosure.

FIG. 7 is a view illustrating a coil structure of a wireless power receiver according to various embodiments of the disclosure.

FIG. 8 is a view illustrating a coil structure of a wireless power receiver according to various embodiments of the disclosure.

FIG. 9 is a view illustrating a coil structure of a wireless power receiver according to various embodiments of the disclosure.

FIG. 10 is a view illustrating a coil structure of a wireless power receiver according to various embodiments of the disclosure.

FIG. 11 is a view illustrating a coil structure of a wireless power receiver according to various embodiments of the disclosure.

FIG. 12 is a circuit diagram of a wireless power receiver according to various embodiments of the disclosure.

FIG. 13A is a graph illustrating a relationship between characteristic resistance and an output voltage according to various embodiments of the disclosure.

FIG. 13B is a graph illustrating a relationship between characteristic resistance and an output voltage according to various embodiments of the disclosure.

FIG. 13C is a graph illustrating a relationship between characteristic resistance and an output voltage according to various embodiments of the disclosure.

FIG. 13D is a graph illustrating a relationship between characteristic resistance and an output voltage according to various embodiments of the disclosure.

FIG. 13E is a graph illustrating a relationship between characteristic resistance and an output voltage according to various embodiments of the disclosure.

FIG. 13F is a graph illustrating a relationship between characteristic resistance and an output voltage according to various embodiments of the disclosure.

FIG. 14 is a block diagram of an electronic device within a network environment according to various embodiments of the disclosure.

[Mode for Carrying out the Invention]

Hereinafter, preferable embodiments of the disclosure will be described more specifically with reference to the accompanying drawings. It should be noted that same reference numerals are used for the same components everywhere in the drawings. In connection with describing the disclosure and drawings, if detailed descriptions of relevant known functions or configurations are deemed likely to obscure the gist of the disclosure, the specific descriptions thereof will be omitted.

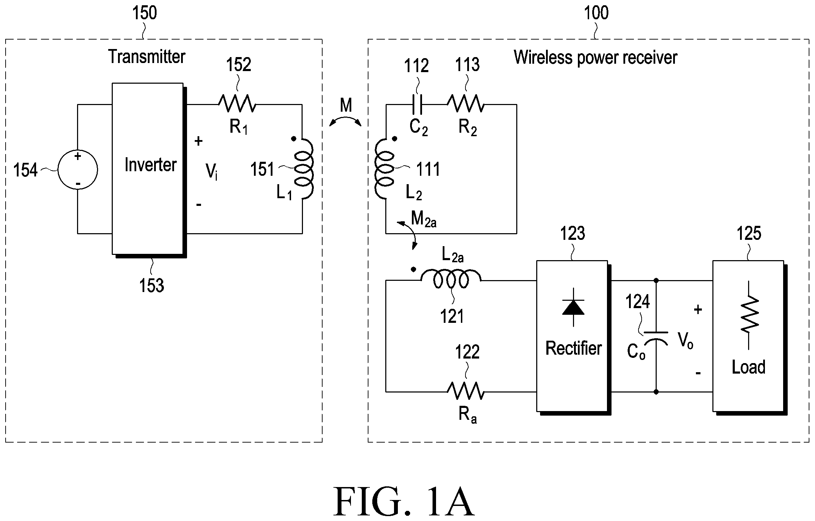

FIG. 1A is a circuit diagram of a wireless power transmitter and a wireless power receiver according to various embodiments of the disclosure. Referring to FIG. 1A, a wireless charging system may include a wireless power transmitter 150 (for example, power transmitting unit (PTU)) and at least one wireless power receiver 100 (for example, power receiving unit (PRU).

The wireless power transmitter 150 may wirelessly transmit power to at least one wireless power receiver 100. The wireless power transmitter 150 may configure an electrical connection with the wireless power receiver 100. For example, the wireless power transmitter 150 may transmit wireless power in an electromagnetic wave type to the wireless power receiver 100. The wireless power transmitter 150 may wirelessly provide power to the wireless power receiver 100. For example, the wireless power transmitter 150 may transmit power to the wireless power receiver 100 via a resonance scheme. The expression of transmitting or sending power to the wireless power receiver 100 by the wireless power transmitter 150 may be understood that the wireless power transmitter 100 radiates or outputs a signal (for example, an electric field, a magnetic field, an electromagnetic wave, a super-high frequency) including power or energy, so that the wireless power receiver 100 collects at least a part of power emitted or output from the wireless power transmitter 150.

In case that the wireless power transmitter 150 adopts a resonance scheme, a distance between the wireless power transmitter 150 and the wireless power receiver 100 may be, for example, 30 m or less, but it is not limited thereto. In addition, in case that the wireless power transmitter 150 adopts an electromagnetic induction scheme, a distance between the wireless power transmitter 150 and the wireless power receiver 100 may be, for example, 10 cm or less, but it is not limited thereto.

The wireless power transmitter 150 may include an inverter 153, a transmitting coil ($L_1$) 151 and a resistance ($R_1$) 152. The inverter 153 may receive a direct current power 154 to output an alternating current power. For example, in case that the wireless power transmitter 150 transmits power via a resonance scheme, the inverter 153 may output an alternating current power of a resonance frequency (for example, 6.78 Mhz) corresponding to a resonance scheme. The inverter 153 may include at least one switch (for example, metal-oxidesemiconductor field-effect transistor (MOSFET)). The alternating current power output from the inverter 153 may be emitted in a type of an electric field, a magnetic field, an electromagnetic wave or a super-high frequency via the transmitting coil 151.

The wireless power receiver 100 may include two coils which are magnetically coupled to configure a parallel resonance. For example, the wireless power receiver 100 may include a coil ($L_2$) 111 and an auxiliary reception coil ($L_{2a}$) 121 which are inductively coupled to each other. The coil 111 may configure a loop with a first capacitor ($C_2$) 112 to configure a resonance circuit. Inner resistance of the coil 111 may be indicated as a first resistance ($R_2$) 113. The auxiliary reception coil 121 may be connected to a rectifier 123. Inner resistance of the auxiliary reception coil 121 may be indicated as a second resistance ($R_a$) 112.

The coil 111 configuring the resonance circuit may wirelessly receive power transmitted from the transmitting coil 151 of the wireless power transmitter 150. When mutual inductance between the transmitting coil 151 of the wireless power transmitter 150 and the coil 111 of the wireless power receiver 100 is M, the M may be expressed by equation 1 below.

$$【\text{Equation 1}】$$
$$M = k\sqrt{L_1 L_2}$$

In equation 1, $L_1$ may indicate self-inductance of the transmitting coil 151 of the wireless power transmitter 150, and $L_2$ may indicate self-inductance of a coil 111 of the wireless power receiver 100. k may be a coupling coefficient and may have a value between 0 and 1. The k may be expressed by equation 2 below, from equation 1.

$$【\text{Equation 2}】$$
$$k = \frac{M}{\sqrt{L_1 L_2}}$$

The coupling coefficient k may indicate a degree by which magnetic flux generated from the transmitting coil 151 configuring a resonance circuit of the wireless power transmitter 150 is used for substantially generating a current to the coil 111 configuring the resonance circuit of the wireless power receiver 110.

The power received from the coil 111 configuring the resonance circuit may be magnetically induced into the auxiliary reception coil 121 which is inductively coupled to the coil 111. The power induced into the auxiliary reception coil 121 may be rectified into a direct current power through the rectifier 123 and then supplied to a load 125. A capacitor 124 may be connected between the rectifier 123 and the load 125 in parallel. The rectifier 123 and the capacitor 124 may be included in a reception circuit unit.

In case that mutual inductance between the coil 111 configuring the resonance circuit of the wireless power receiver 100 and the auxiliary reception coil 121 indicates $M_{2a}$, the $M_{2a}$ may be expressed by equation 3 below.

【Equation 3】

$$M_{2a} = k\sqrt{L_2 L_{2a}}$$

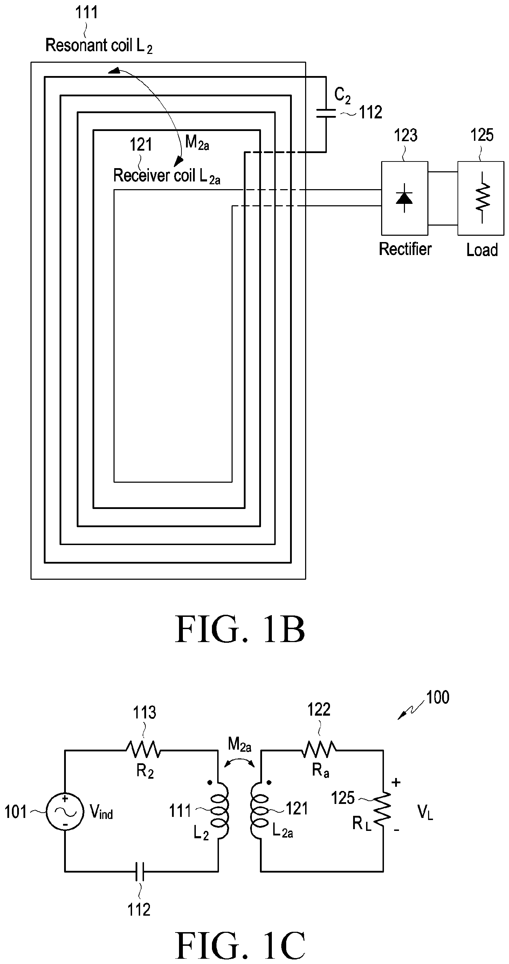

FIG. 1B is a view illustrating a coil structure of a wireless power receiver according to various embodiments of the disclosure. Referring to FIG. 1B, the coil 111 may be connected to the first capacitor 112 to configure a loop, so as to configure a resonance circuit. The coil 111 may include a plurality of turns, and FIG. 1B illustrates that the coil 111 turns four times. The auxiliary reception coil 121 may be disposed in the coil 111. For example, the auxiliary reception coil 121, which includes at least one turn, may be disposed inside the innermost turn of the coil 111. The auxiliary reception coil 121 may be connected to the rectifier 123 and the load 125.

As described in the circuit diagram of FIG. 1A, the coil 111 configuring the resonance circuit and the auxiliary reception coil 121 are inductively coupled to configure a parallel resonance. The wireless power received from the coil 111 may be transmitted to the auxiliary reception coil 121 by magnetic-inductance. The power induced into the auxiliary reception coil 121 may be supplied to the rectifier 123. The mutual inductance between the coil 111 and the auxiliary reception coil 121 may be indicated as the $M_{2a}$ as expressed by equation 3.

In case that a plurality of coils (for example, the coil 111 and the auxiliary reception coil 121) are mounted in the housing of the wireless power receiver 100, an area for configuring a multi-coil by the plurality of coils may be limited and the thickness of the wireless power receiver may increase as a layer increases when the plurality of coils are arranged. In addition, in case that a coil pattern is added to the wireless power receiver 100, the manufacturing cost of a flexible printed circuit board (FPCB) may increase.

FIG. 1C is a circuit diagram of a wireless power receiver according to various embodiments of the disclosure. Referring to FIG. 1C, the coil 111 and the auxiliary reception coil 121 illustrated in FIG. 1B may be indicated as an equivalent circuit.

In the circuit of FIG. 1C, voltage $V_L$ applied to a load may be expressed by equation 4 below.

【Equation 4】

$$V_L = \frac{jV_{ind}Z_0R_L}{\omega M_{2a}(Z_0 + j\omega L_{2a} + R_a + R_L)}$$

In wireless charging in the long distance, in case that the load impedance $R_L$ is relatively large, $V_L$ may be higher than $V_{ind}$ by using a parallel resonance as illustrated in FIG. 1B. In equation 4, $Z_0$ may indicate impedance viewed from the load, and equation 5 below may be induced from equation 4.

【Equation 5】

$$Z_0 = \frac{(\omega M_{2a})^2}{j\omega L_2 + \dfrac{1}{j\omega C_2} + R_2}$$

Referring to equation 4 and equation 5, it may be identified that the inductance $L_{2a}$ of the auxiliary reception coil 121 added to the coil 111 of the wireless power receiver 100 may reduce performance of the wireless power receiver 100 configuring a parallel resonance.

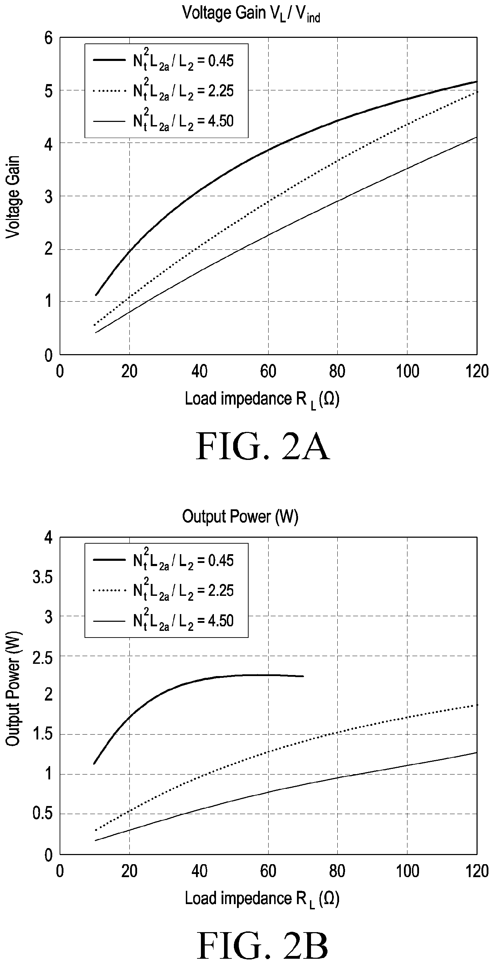

FIG. 2A is a graph illustrating a relationship between load impedance and a voltage gain according to various embodiments of the disclosure. FIG. 2A may indicate a relationship between a voltage gain and load impedance RL applied to the load 125 when multiplication of the number Nt of turns of the coil 111 configuring the resonance circuit and a ratio of the inductance $L_{2a}$ of the auxiliary reception coil 121 and the inductance $L_2$ of the coil 111 is 0.45, 2.25, 4.5.

Referring to FIG. 2A, the greater the load impedance RL applied to the load 125, the higher a voltage gain. According to various embodiments, the voltage gain may vary in the same load impedance according to the number Nt of turns of the coil 111 configuring the resonance circuit and a ratio of the inductance $L_{2a}$ of the auxiliary reception coil 121 and the inductance $L_2$ of the coil 111. For example, even in the same load impedance, the smaller the radio of the inductance $L_{2a}$ of the auxiliary reception coil 121 to the inductance $L_2$ of the coil 111 configuring the resonance circuit, the higher the voltage gain.

FIG. 2B is a graph illustrating a relationship between load impedance and an output power according to various embodiments of the disclosure. FIG. 2B may indicate a relationship between an output power and load impedance RL applied to the load 125 when multiplication of the number Nt of turns of the coil 111 configuring the resonance circuit and a ratio of the inductance $L_{2a}$ of the auxiliary reception coil 121 and the inductance $L_2$ of the resonant coil is 0.45, 2.25, 4.5.

Referring to FIG. 2B, the greater the load impedance RL applied to the load 125, the higher the output power in at least a section. According to various embodiments, the voltage gain may vary in the same load impedance according to the number Nt of turns of the coil 111 configuring the resonance circuit and a ratio of the inductance $L_{2a}$ of the auxiliary reception coil 121 and the inductance $L_2$ of the coil 111. For example, even in the same load impedance, the smaller the radio of the inductance $L_{2a}$ of the auxiliary reception coil 121 to the inductance $L_2$ of the coil 121 configuring the resonance circuit, the higher the output power.

In various embodiments described later, performance in a parallel resonance coil may be improved by reducing or minimizing the inductance $L_{2a}$ of the auxiliary reception coil 121.

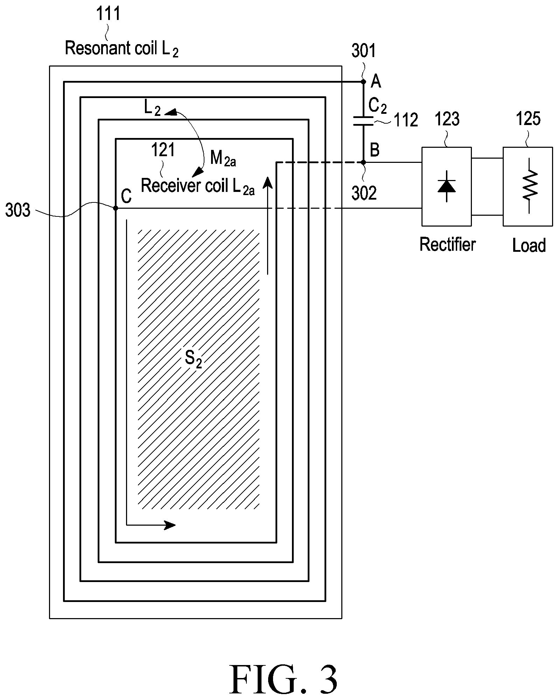

FIG. 3 is a view illustrating a coil structure of a wireless power receiver according to various embodiments of the disclosure. Referring to FIG. 3, the coil 111 may be connected to the first capacitor 112 to configure a loop, so as to configure a resonance circuit. The first capacitor 112 may be connected to opposite ends of the coil 111, a point 301 indicated as A may be designated as a "Go" line, and a point 302 indicated as B may be designated as a "Return" line. The coil ($L_2$) 111 may start from the A point 301 and be wound in a counterclockwise direction and may be connected to the first capacitor 112 at the B point 302 to configure a loop. The coil 111 may configure a plurality of turns (for example, four turns).

According to various embodiments, a tap may be configured at a C point 303 of the innermost turn among a plurality of turns of the coil 111 and a loop coil including or sharing a part of the innermost turn of the coil 111 may be configured by short-circuiting the B point 302 corresponding to a return line of the coil 111. The configured loop coil may be connected to the rectifier 123 to operate as the auxiliary reception coil 121. The auxiliary reception coil 121 including a part of the innermost turn of the coil 111 may configure an interlinkage area $S_2$ and a loop of the coil 111. An interlinkage area may be changed by changing the location of the C point 303, and performance of the wireless power receiver 100 may vary according to the change of the interlinkage area.

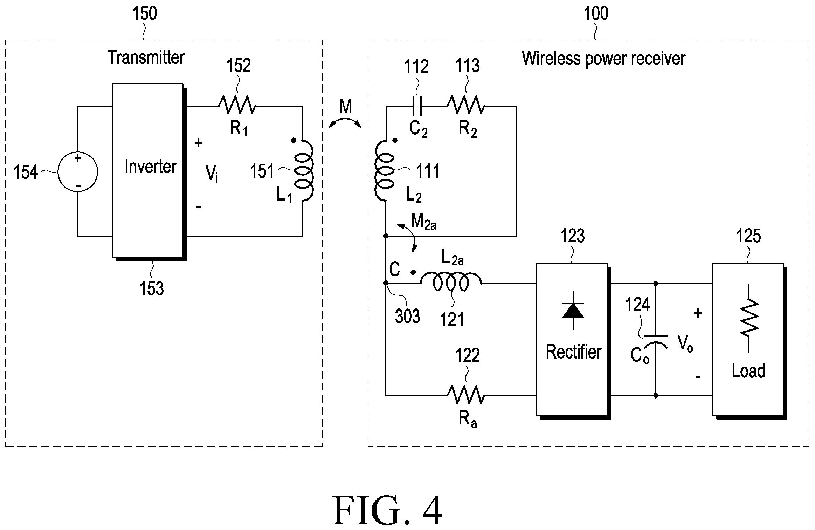

The connection structure of FIG. 3 may be expressed as a circuit diagram as shown in FIG. 4. FIG. 4 is a circuit diagram of a wireless power receiver according to various embodiments of the disclosure. Referring to FIG. 4, it may be identified that a receiving coil 121 is connected at the C point 303 of the coil 111 in comparison with FIG. 1A.

According to various embodiments, as described in FIG. 2A and FIG. 2B, the performance of the wireless power receiver may be increased by controlling the number Nt of turns of the coil 111 configuring the resonance circuit and a ratio of the inductance $L_2$ of the coil and the inductance $L_{2a}$ of the auxiliary reception coil. Referring to the FIG. 3, a tap is configured at one point of the innermost turn of the coil 111 configuring the resonance circuit, to configure an auxiliary reception coil, so that an area occupied by the plurality of coils may be reduced. When a point at which the tap is configured is controlled in the innermost turn of the coil 111, the inductance $L_{2a}$ of the auxiliary reception coil may be changed. According to various embodiments, by controlling a point at which the tap is configured in the innermost turn of the coil 111, performance of the wireless power receiver may be increased.

As the result of experiment of FIG. 2A and FIG. 2B, the number Nt of turns of the coil configuring a resonance circuit and the ratio of the inductance $L_2$ of the coil and the inductance $L_{2a}$ of the auxiliary reception coil configure the tap to satisfy equation 6 below, so that performance of the receiver may be increased.

【Equation 6】

$$\frac{N_t^2 L_{2a}}{L_2} < K_1$$

In equation 6, $K_t$ may be defined as a coil constant according to a coil type. According to various embodiments, as illustrated in FIG. 3, in case that the auxiliary reception coil 121 configures an area smaller than an area configured by the innermost coil of the coil, the coil constant may be configured as 2, and in case that the auxiliary reception coil configures a plurality of layers with the coil configuring the resonance circuit, the coil constant may be configured as 1.

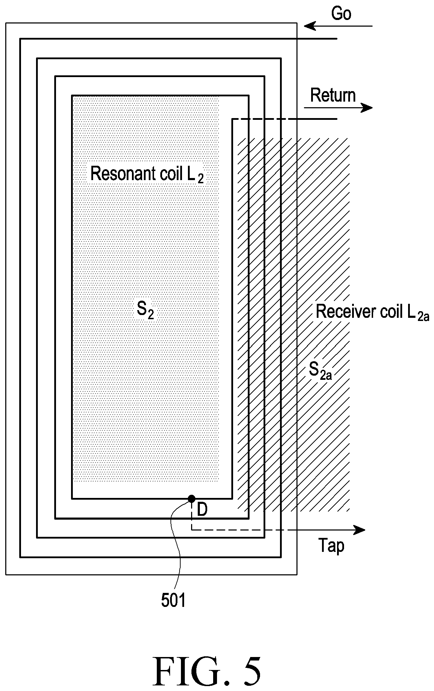

FIG. 5 is a view illustrating a coil structure of a wireless power receiver according to various embodiments of the disclosure. Referring to FIG. 5, in case that a tap is configured at a D point 501 which is a lower end part of the innermost turn among the plurality of turns of the coil 111 configuring the resonance circuit, the interlinkage area $S_{2a}$ may be configured at the right side of the auxiliary reception coil 121. In comparison with FIG. 3, the wireless charging reception performance may be more reduced in FIG. 5.

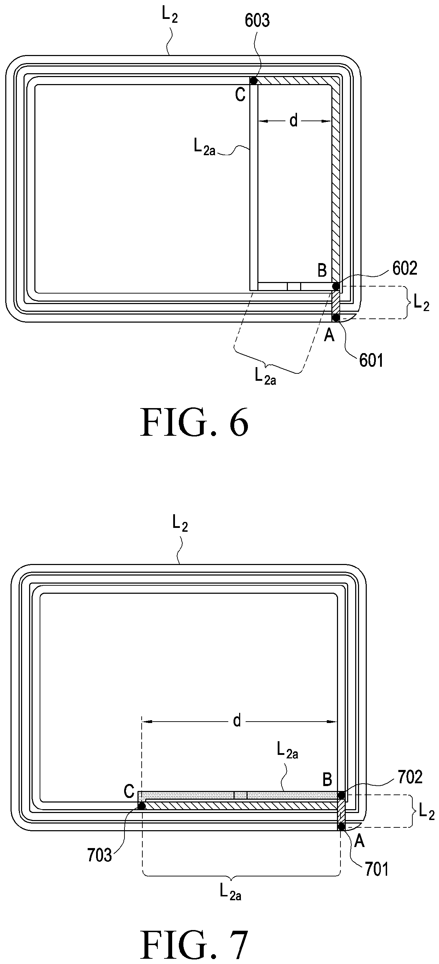

FIG. 6 is a view illustrating a coil structure of a wireless power receiver according to various embodiments of the disclosure. Referring to FIG. 6, the coil $L_2$ configuring a resonance circuit may be connected to an A point 601 and a B point 602 to configure a loop, and may be inductively coupled to an auxiliary reception coil. According to various embodiments, the auxiliary reception coil $L_{2a}$ may configure a tap at the C point 603 which is an upper point of the innermost turn of the coil configuring the resonance circuit, and may configure the loop by short-circuiting the B point 602. In FIG. 6, the width of the auxiliary reception coil may be indicated as d.

According to various embodiments, according to the change of the location of the C point 603 configuring the tap, the width d of the auxiliary reception coil, the inductance $L_2$ of the coil configuring the resonance circuit, the inductance $L_{2a}$ of the auxiliary reception coil, a coupling coefficient k, and $N_t^2 L_{2a}/L_2$ may be identified as Table 1 below. In FIG. 6, Nt may be 3 and $K_t$ may be 2.

[Table 1]

| d(mm) | $L_2(\mu H)$ | $L_{2a}(\mu H)$ | k | $N_t^2 L_{2a}/L_2$ |
|---|---|---|---|---|
| 20 | 1.624702 | 0.122857 | 0.3433 | 0.680564 |
| 40 | 1.622192 | 0.175911 | 0.46603 | 0.975963 |
| 40 | 1.617382 | 0.223275 | 0.58553 | 1.242424 |

Referring to Table 1, the location of the C point 603 configuring the tap is changed, so that performance of the wireless power receiver 100 may be increased by controlling $Nt^2 L_{2a}/L_2$. FIG. 7 is a view illustrating a coil structure of a wireless power receiver according to various embodiments of the disclosure. Referring to FIG. 7, the coil $L_2$ configuring a resonance circuit may be connected to the A point 701 and the B point 702 to configure a loop, and may be inductively coupled to the auxiliary reception coil $L_{2a}$. According to various embodiments, the tap may be configured at the C point 703 which is a lower part of the innermost turn of the coil $L_2$ configuring the resonance circuit and the loop may be configured by short-circuiting the B point 602. In FIG. 7, the width of the auxiliary reception coil may be indicated as d.

According to various embodiments, according to the change of the location of the C point 703 configuring the tap, the width d of the auxiliary reception coil, the inductance $L_2$ of the coil configuring the resonance circuit, the inductance $L_{2a}$ of the auxiliary reception coil, a coupling coefficient k, and $N_t^2 L_{2a}/L_2$ may be identified as Table 2 below. In FIG. 7, Nt may be 3 and $K_t$ may be 2.

[Table 2]

| d(mm) | $L_2(\mu H)$ | $L_{2a}(\mu H)$ | k | $N_t^2 L_{2a}/L_2$ |
|---|---|---|---|---|
| 20 | 1.624704 | 0.245186 | -0.79229 | 1.358201 |
| 40 | 1.621598 | 0.244992 | -0.76943 | 1.359725 |
| 40 | 1.617373 | 0.244203 | -0.74626 | 1.358887 |

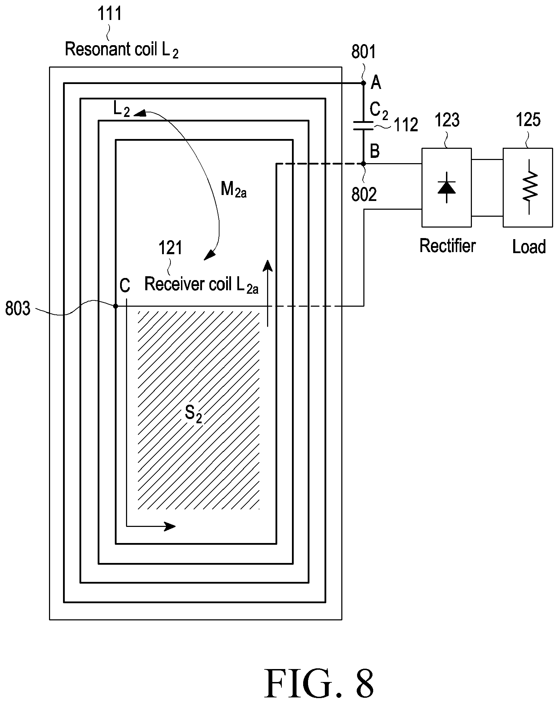

Referring to Table 2, the location of the C point 703 configuring the tap is changed, so that performance of the wireless power receiver 100 may be increased by controlling $N_t^2 L_{2a}/L_2$. Hereinafter, referring to FIG. 8 to FIG. 11, various embodiments configuring the auxiliary reception coil in the innermost turn of the coil configuring the resonance circuit will be described.

FIG. 8 is a view illustrating a coil structure of a wireless power receiver according to various embodiments of the disclosure. Referring to FIG. 8, the coil 111 may be connected to the first capacitor 112 to configure a loop, so as to configure the resonance circuit. The first capacitor 112 may be connected to opposite ends of the coil 111 to configure the resonance circuit. A point 801 indicated as A may be designated as a "Go" line, and a point 802 indicated as B may be designated as a "Return" line. The coil ($L_2$) 111 configuring the resonance circuit may start from the A point 801 and be wound in a counterclockwise direction and may be connected to the first capacitor 112 at the B point 802 to configure a loop. The coil 111 may configure a plurality of turns (for example, four turns).

According to various embodiments, a tap may be configured at a C point 803 of the innermost turn of the plurality of turns of the coil 111, and the loop which includes or shares a part of the innermost turn of the coil 111 may be configured by short-circuiting the B point 802 corresponding to a return line of the coil 111. The configured loop may be connected to the rectifier 123 to configure the auxiliary reception coil 121. The auxiliary reception coil 121 including a part of the innermost turn of the coil 111 configuring the resonance circuit may configure the interlinkage area $S_2$ and the loop of the coil 111. The interlinkage area may be changed as the location of the C point 803 is changed, and performance of the wireless power receiver 100 may vary according to the change of the interlinkage area.

Referring to FIG. 8, in comparison with FIG. 3, the C point 803 may relatively move downwards, and thus the interlinkage area $S_2$ may be reduced. According to the change of the C point 803, the width d of the auxiliary reception coil may vary, and as illustrated in Table 1, the $N_t^2 L_{2a}/L_2$ is controlled so that performance of the wireless power receiver 100 may vary. According to various embodiments, the C point 803 at which the tap is configured in the innermost turn of the coil 111 configuring a resonance circuit is controlled, so that performance of the wireless power receiver may be increased. For example, as illustrated in FIG. 8, the tap configuring the interlinkage area $S_2$ may be configured at the innermost turn of the coil 111 configuring the resonance circuit, so that the loop of the auxiliary reception coil 121 in which a part of the innermost turn of the coil 111 is shared may be configured. As above, the auxiliary reception coil 121 is configured so that a magnet-coupling may be increased, and self-inductance $L_{2a}$ of the mutual inductance $M_{2a}$ and the auxiliary reception coil 121 may be reduced. In addition, a part of the innermost turn of the coil 111 configuring the resonance circuit is shared with the auxiliary reception coil 121, so that an area occupied by the entire coil may be reduced.

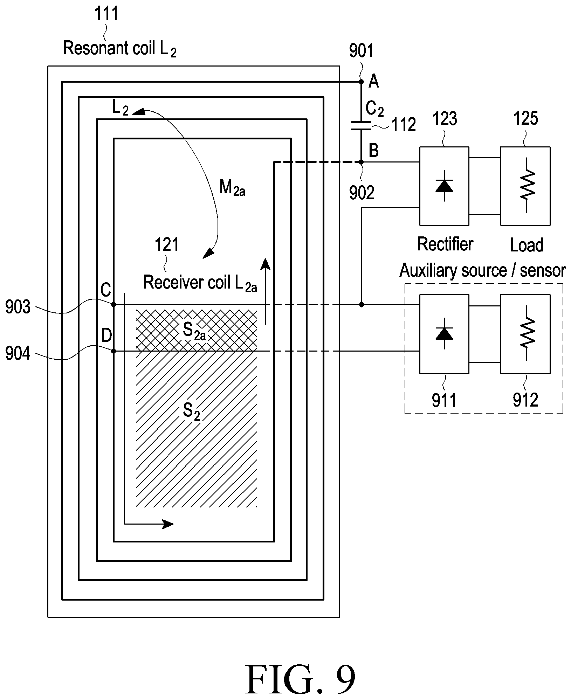

FIG. 9 is a view illustrating a coil structure of a wireless power receiver according to various embodiments of the disclosure. Referring to FIG. 9, the coil 111 is connected to the first capacitor 112 to configure a loop, so as to configure a resonance circuit. The first capacitor 112 may be connected to opposite ends of the coil 111 to configure the resonance circuit. A point 901 indicated as A may be designated as a "Go" line, and a point 902 indicated as B may be designated as a "Return" line. The coil ($L_2$) 111 may start from the A point 901 and be wound in a counterclockwise direction and may be connected to the first capacitor 112 at the B point 902 to configure the loop, so as to configure the resonance circuit. The coil 111 may configure a plurality of turns (for example, four turns).

According to various embodiments, a tap may be configured at the C point 903 of the innermost turn of the plurality of turns of the coil 111, and a loop which includes or shares a part of the innermost turn of the coil 111 may be configured by short-circuiting the B point 902 corresponding to a return line of the coil 111. The configured loop may configure a first auxiliary reception coil which is connected to the first rectifier 123. The auxiliary reception coil 121 including a part of the innermost turn of the coil 111 may configure the interlinkage area $S_2$ and the loop of the coil 111. An interlinkage area may be changed as the location of the C point 903 is changed, and performance of the wireless power receiver 100 may vary according to the change of the interlinkage area.

According to various embodiments, a tap may be configured at a D point 904 of the innermost turn of the plurality of turns of the coil 111, and a loop which includes or shares a part of the innermost turn of the coil 111 may be additionally configured by short-circuiting the C point 903 of the first auxiliary reception coil. The additionally configured loop may configure the second auxiliary reception coil connected to the second rectifier 911 and the second load 912. The second auxiliary reception coil including a part of the innermost turn of the coil 111 may configure the interlinkage area $S_2$ and the loop of the coil 111. The interlinkage area may be changed as locations of the C point 903 and the D point 904 are changed, and performance of the wireless power receiver 100 may vary according to the change of the interlinkage area. The interlinkage area $S_{2a}$ configured by the second auxiliary reception coil may be relatively smaller than the interlinkage area $S_2$ configured by the first auxiliary reception coil, and the size of power induced into the second rectifier 911 and the second load 912 may be relatively smaller than the size of power induced into the first rectifier 123 and the first load 125.

According to various embodiments, power received thorough the first auxiliary reception coil may be used as a main power of the wireless power receiver 100, and power received through the second auxiliary reception coil may be used as a power supply of an auxiliary power supply (auxiliary source) or a sensor, etc.

FIG. 9 illustrates supplying two power supplies by configuring two taps to configure two auxiliary reception coils, but it is possible to configure three or more taps to configure three or more auxiliary reception coils according to various embodiments.

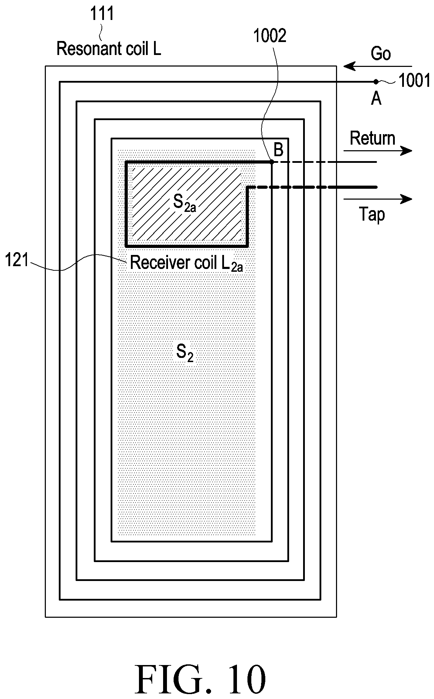

FIG. 10 is a view illustrating a coil structure of a wireless power receiver according to various embodiments of the disclosure. Referring to FIG. 10, the coil 111 is connected to the first capacitor 112 to configure a loop, so as to configure a resonance circuit. The first capacitor 112 may be connected to opposite ends of the coil 111 to configure the resonance circuit. A point 1001 indicated as A may be designated as a "Go" line, and a point 1002 indicated as B may be designated as a "Return" line. The coil ($L_2$) 111 configuring the resonance circuit may start from the A point 1001 and be wound in a counterclockwise direction and may be connected to the first capacitor 112 at the B point 1002 to configure a loop. The coil 111 may configure a plurality of turns (for example, four turns).

According to various embodiments, a tap may be configured at the B point 1002 of the coil 111 configuring the resonance circuit, and the additional coil may be configured in the innermost turn of the coil 111. The additional coil may be connected to the rectifier 123 to configure the auxiliary reception coil. The auxiliary reception coil 121 additionally configured in the innermost turn of the coil 111 may configure the interlinkage area $S_{2a}$ and the loop of the coil 111.

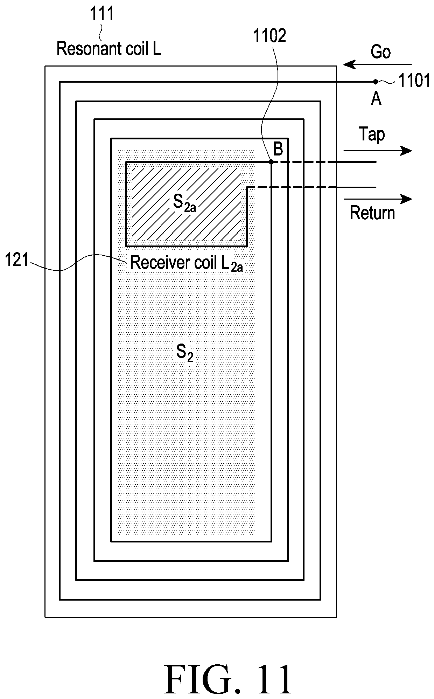

FIG. 11 is a view illustrating a coil structure of a wireless power receiver according to various embodiments of the disclosure. Referring to FIG. 11, the coil 111 is connected to the first capacitor 112 to configure the loop, so as to configure the resonance circuit. The first capacitor 112 may be connected to opposite ends of the coil 111 to configure the resonance circuit. A point 1101 indicated as A may be designated as a "Go" line. The coil 111 may configure a plurality of turns (for example, four turns).

According to various embodiments, the tap may be configured at the B point 1102 of the coil 111 configuring the resonance circuit, and the additional coil may be configured in the innermost turn of the coil 111. The additional coil may be connected to the rectifier 123 to configure the auxiliary reception coil. The auxiliary reception coil 121 additionally configured in the innermost turn of the coil 111 may configure the interlinkage area $S_{2a}$ and the loop of the coil 111.

The coil ($L_2$) 111 configuring the resonance circuit may start from the A point 1101 and be wound in a counterclockwise direction and may pass via the auxiliary reception coil 121 at the B point 1102 to configure a "Return" line. According to various embodiments, in comparison with FIG. 11 and FIG. 10, it may be identified that the coil 111 configuring the resonance circuit is shared and extends as much as the additional auxiliary reception coil 121.

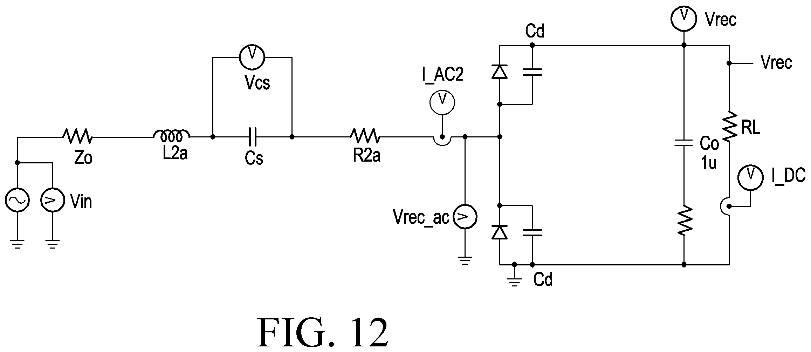

FIG. 12 is a circuit diagram of a wireless power receiver according to various embodiments of the disclosure. Referring to FIG. 12, the case that a capacitor is added to the auxiliary reception coil 121 of FIG. 4 and connected in series may be simulated by the circuit as illustrated.

According to the result of the simulation of FIG. 12, characteristic resistance of a multi-loop coil may be defined as equation 7 below.

【Equation 7】

$$R_e = k^2 \omega L_{2a}$$

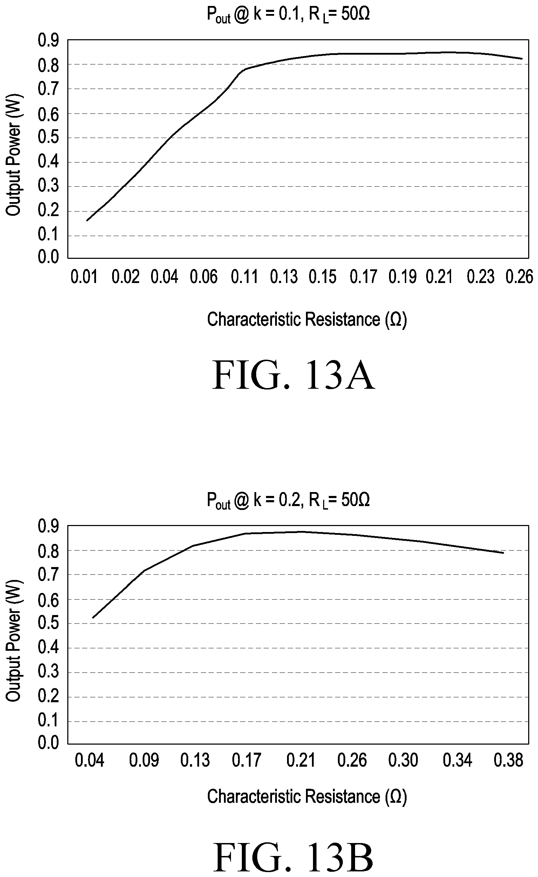

According to various embodiments, referring to FIG. 13A to 13F, in case that the characteristic resistance is between 0.1 and 1, the relatively high performance (for example, output power) may be indicated.

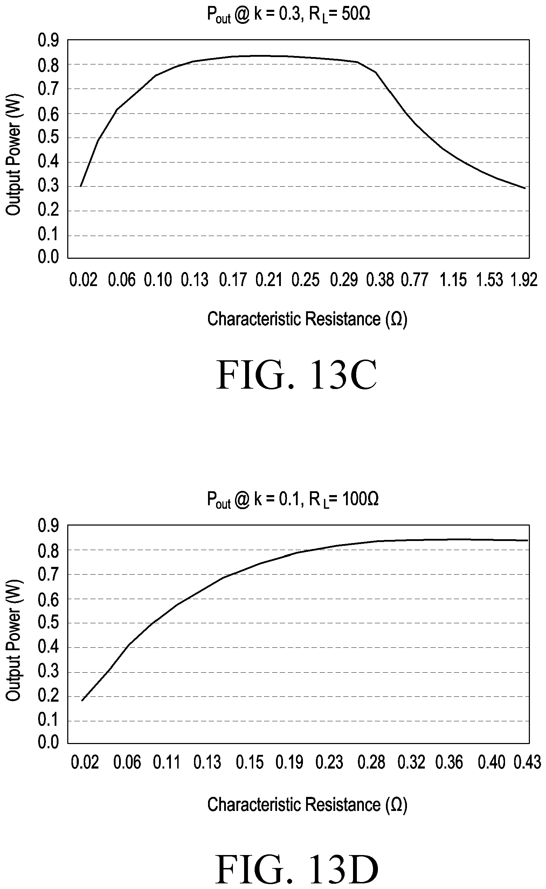

FIG. 13A is a graph illustrating a relationship between characteristic resistance and an output power in case that the load impedance $R_L$ is 50 Ω and the K is 0.1, FIG. 13B is a graph illustrating a relationship between characteristic resistance and an output power in case that the load impedance $R_L$ is 50 Ω and the K is 0.2, and FIG. 13C is a graph illustrating a relationship between characteristic resistance and an output power in case that the load impedance $R_L$ is 50 Ω and the K is 0.3. Referring to FIG. 13A, FIG. 13B, and FIG. 13C, it may be identified that the characteristic resistance may indicate a relatively high output voltage between 0.1 and 1.

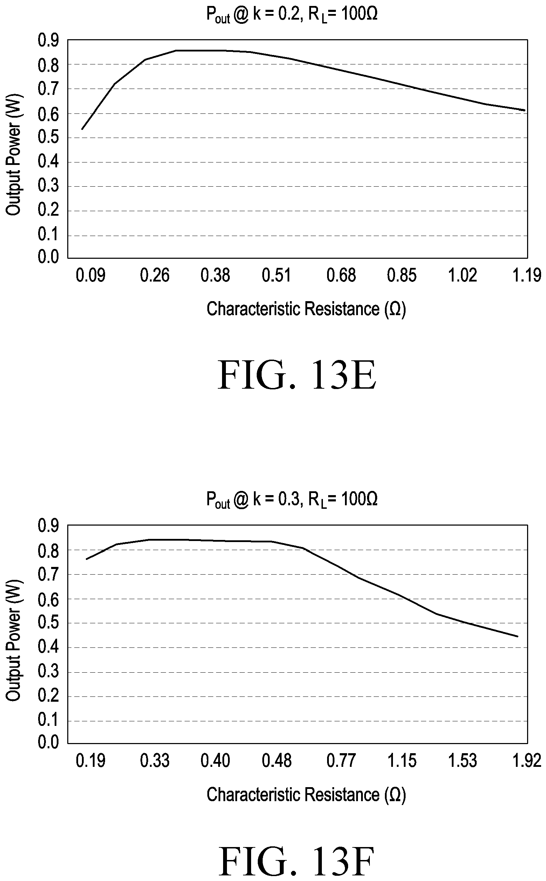

FIG. 13D is a graph illustrating a relationship between characteristic resistance and an output power in case that the load impedance $R_L$ is 100 Ω and the K is 0.1, FIG. 13E is a graph illustrating a relationship between characteristic resistance and an output power in case that the load impedance $R_L$ is 100 Ω and the K is 0.2, and FIG. 13F is a graph illustrating a relationship between characteristic resistance and an output power in case that the load impedance $R_L$ is 100 Ω and the K is 0.3. Referring to FIG. 13D, FIG. 13E, and FIG. 13F, it may be identified the characteristic resistance may indicate a relatively high output voltage between 0.1 and 1.

According to various embodiments, the range of the characteristic resistance may be indicated as the range of the output impedance $Z_0$. For example, a Q-factor may be indicated as $Z_0/R_e$, so that the output impedance $Z_0$ may be induced as equation 8 below.

【Equation 8】

$$Z_0 = k^2 \omega L_{2a} Q_2$$

Referring to equation 8, the output impedance may indicate relatively high performance between 10 and 100 in case that the Q-factor is 100, the output impedance may indicate relatively high performance between 5 and 50 in case that the Q-factor is 50, and the output impedance may indicate relatively high performance between 1 and 10 in case that the Q-factor is 10. According to various embodiments, performance of the wireless power receiver may be increased or optimized by controlling the output impedance in consideration of the Q-factor.

A wireless power receiver according to an embodiment of various embodiments may include a resonant circuit including a coil having a plurality of turns and receiving power transmitted from a wireless power transmitter, an auxiliary reception coil inductively coupled to the coil and configured to establish a tap at a first point of the innermost turn among the plurality of turns of the coil to establish a loop including a part of the innermost turn of the coil, and a reception circuit unit electrically connected to the auxiliary reception coil and configured to process power induced into the auxiliary reception coil based on power received by the resonance circuit.

According to various embodiments, a location of the first point may be configured based on the inductance of the coil and the inductance of the auxiliary reception coil.

According to various embodiments, a first point location may be configured such that a ratio of the inductance of the auxiliary reception coil and the inductance of the coil is to have a value less than a configured value.

According to various embodiments, the location of the first point may be configured based on the number of the plurality of turns of the coil.

According to various embodiments, the location of the first point may be configured such that the inductance of the auxiliary reception coil is less than a predetermined value.

According to various embodiments, the location of the first point may be configured based on equation 9 below.

【Equation 9】

$$\frac{N^2{}_t L_{2a}}{L_2} < K_t$$

Herein, $N_k$ may indicate the number of turns of the coil, $L_2$ may indicate inductance of the coil, and $L_{2a}$ may indicate inductance of the auxiliary reception coil.

According to various embodiments, the coil constant may be configured as 2, in case that the auxiliary reception coil configures an area having a size smaller than that of an area configured by the innermost coil of the coil.

According to various embodiments, the coil constant may be configured as 1, in case that the auxiliary reception coil may configure multiple layers with the coil.

According to various embodiments, the auxiliary reception coil may be configured in the innermost coil of the coil to generate the interlinkage area.

According to various embodiments, the location of the first point may be configured so that the interlinkage area has a value smaller than a configured value.

According to various embodiments, the location of the first point may be configured so that coupling coefficient between the coil and the auxiliary reception coil has a value larger than a configured value.

According to various embodiments, the location of the first point may be configured so that the inductance of the auxiliary reception coil has a value smaller than a configured value.

According to various embodiments, the auxiliary reception coil may configure a first tap at the first point of the innermost turn among the plurality of turns of the coil, and configure a second tap at the second point of the innermost turn among the plurality of turns of the coil.

According to various embodiments, in the auxiliary reception coil, a first auxiliary reception coil may be configured through a loop configured by the first tap, and a second auxiliary reception coil may be configured through a loop configured by a second tap.

According to various embodiments, the first auxiliary reception coil may be connected to a first reception circuit unit and the second auxiliary reception coil may be connected to a second reception circuit unit.

According to various embodiments, power supplied to the first reception circuit unit may be larger than power supplied to the second reception circuit unit.

According to various embodiments, the location of the first point may be configured based on impedance matching with the wireless power transmitter which transmits power to the wireless power receiver.

According to various embodiments, the location of the first point may be configured based on a value between 0.1 and 1 of the characteristic resistance $R_e$ of the auxiliary reception coil by equation 10 below.

【Equation 10】

$$R_e = k^2 \omega L_{2a}$$

Herein, k may indicate the coupling coefficient, $\omega$ may indicate an angular frequency, and $L_{2a}$ may indicate impedance of the auxiliary reception coil.

A wireless power receiver according to one among the various embodiments may include a resonance circuit including a coil having a plurality of turns and receiving power transmitted from the wireless power transmitter, and an auxiliary reception coil configuring a tap at a first point of the innermost turn among the plurality of turns of the coil to configure the loop while including a part of the innermost turn of the coil, and inductively coupled to the coil.

A wireless power receiver according to one of various embodiments may include a resonant circuit including a coil having a plurality of turns and receiving power transmitted from a wireless power transmitter, an auxiliary reception coil inductively coupled to the coil and configured to establish a tap at a first point of the innermost turn among the plurality of turns of the coil to be connected to the coil and to establish at least one turn in the innermost turn of the coil, and a reception circuit unit electrically connected to the auxiliary reception coil and configured to process power induced into the auxiliary reception coil based on power received by the resonance circuit from the auxiliary reception coil.

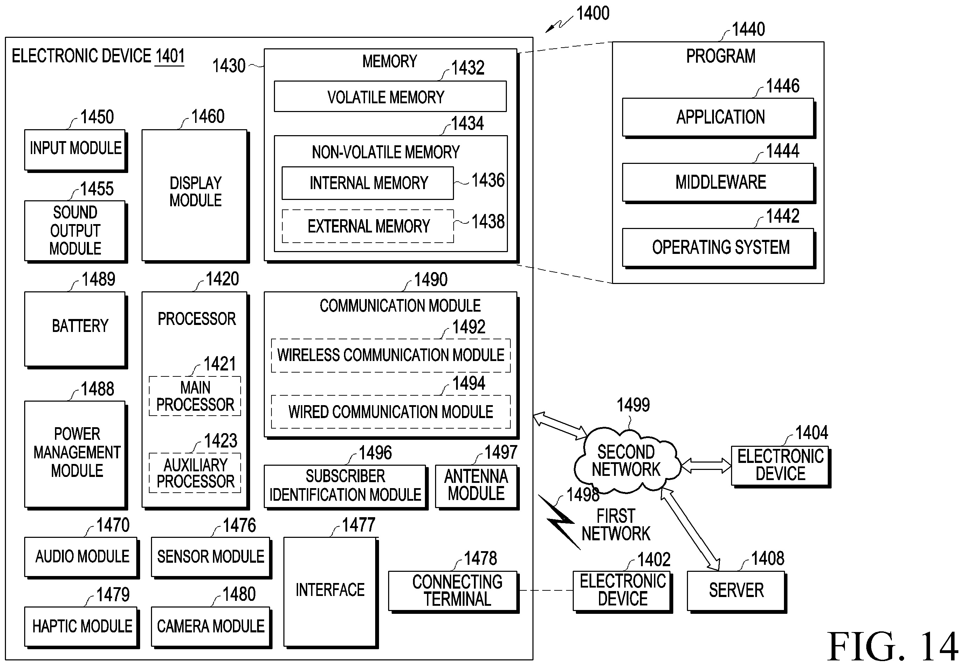

FIG. 14 is a block diagram illustrating an electronic device 1401 in a network environment 1400 according to various embodiments. Referring to FIG. 14, the electronic device 1401 in the network environment 1400 may communicate with an electronic device 1402 via a first network 1498 (e.g., a short-range wireless communication network), or at least one of an electronic device 1404 or a server 1408 via a second network 1499 (e.g., a long-range wireless communication network). According to an embodiment, the electronic device 1401 may communicate with the electronic device 1404 via the server 1408. According to an embodiment, the electronic device 1401 may include a processor 1420, memory 1430, an input module 1450, a sound output module 1455, a display module 1460, an audio module 1470, a sensor module 1476, an interface 1477, a connecting terminal 1478, a haptic module 1479, a camera module 1480, a power management module 1488, a battery 1489, a communication module 1490, a subscriber identification module (SIM) 1496, or an antenna module 1497. In some embodiments, at least one of the components (e.g., the connecting terminal 1478) may be omitted from the electronic device 1401, or one or more other components may be added in the electronic device 1401. In some embodiments, some of the components (e.g., the sensor module 1476, the camera module 1480, or the antenna module 1497) may be implemented as a single component (e.g., the display module 1460).

The processor 1420 may execute, for example, software (e.g., a program 1440) to control at least one other component (e.g., a hardware or software component) of the electronic device 1401 coupled with the processor 1420, and may perform various data processing or computation. According to one embodiment, as at least part of the data processing or computation, the processor 1420 may store a command or data received from another component (e.g., the sensor module 1476 or the communication module 1490) in volatile memory 1432, process the command or the data stored in the volatile memory 1432, and store resulting data in non-volatile memory 1434. According to an embodiment, the processor 1420 may include a main processor 1421 (e.g., a central processing unit (CPU) or an application processor (AP)), or an auxiliary processor 1423 (e.g., a graphics processing unit (GPU), a neural processing unit (NPU), an image signal processor (ISP), a sensor hub processor, or a communication processor (CP)) that is operable independently from, or in conjunction with, the main processor 1421. For example, when the electronic device 1401 includes the main processor 1421 and the auxiliary processor 1423, the auxiliary processor 1423 may be adapted to consume less power than the main processor 1421, or to be specific to a specified function. The auxiliary processor 1423 may be implemented as separate from, or as part of the main processor 1421.

The auxiliary processor 1423 may control at least some of functions or states related to at least one component (e.g., the display module 1460, the sensor module 1476, or the communication module 1490) among the components of the electronic device 1401, instead of the main processor 1421 while the main processor 1421 is in an inactive (e.g., sleep) state, or together with the main processor 1421 while the main processor 1421 is in an active state (e.g., executing an application). According to an embodiment, the auxiliary processor 1423 (e.g., an image signal processor or a communication processor) may be implemented as part of another component (e.g., the camera module 1480 or the communication module 1490) functionally related to the auxiliary processor 1423. According to an embodiment, the auxiliary processor 1423 (e.g., the neural processing unit) may include a hardware structure specified for artificial intelligence model processing. An artificial intelligence model may be generated by machine learning. Such learning may be performed, e.g., by the electronic device 1401 where the artificial intelligence is performed or via a separate server (e.g., the server 1408). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1430 may store various data used by at least one component (e.g., the processor 1420 or the sensor module 1476) of the electronic device 1401. The various data may include, for example, software (e.g., the program 1440) and input data or output data for a command related thereto. The memory 1430 may include the volatile memory 1432 or the non-volatile memory 1434.

The program 1440 may be stored in the memory 1430 as software, and may include, for example, an operating system (OS) 1442, middleware 1444, or an application 1446.

The input module 1450 may receive a command or data to be used by another component (e.g., the processor 1420) of the electronic device 1401, from the outside (e.g., a user) of the electronic device 1401. The input module 1450 may include, for example, a microphone, a mouse, a keyboard, a key (e.g., a button), or a digital pen (e.g., a stylus pen).

The sound output module 1455 may output sound signals to the outside of the electronic device 1401. The sound output module 1455 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1460 may visually provide information to the outside (e.g., a user) of the electronic device 1401. The display module 1460 may include, for example, a display, a hologram device, or a projector and control circuitry to control a corresponding one of the display, hologram device, and projector. According to an embodiment, the display module 1460 may include a touch sensor adapted to detect a touch, or a pressure sensor adapted to measure the intensity of force incurred by the touch.

The audio module 1470 may convert a sound into an electrical signal and vice versa. According to an embodiment, the audio module 1470 may obtain the sound via the input module 1450, or output the sound via the sound output module 1455 or a headphone of an external electronic device (e.g., an electronic device 1402) directly (e.g., wiredly) or wirelessly coupled with the electronic device 1401.

The sensor module 1476 may detect an operational state (e.g., power or temperature) of the electronic device 1401 or an environmental state (e.g., a state of a user) external to the electronic device 1401, and then generate an electrical signal or data value corresponding to the detected state. According to an embodiment, the sensor module 1476 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1477 may support one or more specified protocols to be used for the electronic device 1401 to be coupled with the external electronic device (e.g., the electronic device 1402) directly (e.g., wiredly) or wirelessly. According to an embodiment, the interface 1477 may include, for example, a high definition multimedia interface (HDMI), a universal serial bus (USB) interface, a secure digital (SD) card interface, or an audio interface.

A connecting terminal 1478 may include a connector via which the electronic device 1401 may be physically connected with the external electronic device (e.g., the electronic device 1402). According to an embodiment, the connecting terminal 1478 may include, for example, a HDMI connector, a USB connector, a SD card connector, or an audio connector (e.g., a headphone connector).

The haptic module 1479 may convert an electrical signal into a mechanical stimulus (e.g., a vibration or a movement) or electrical stimulus which may be recognized by a user via his tactile sensation or kinesthetic sensation. According to an embodiment, the haptic module 1479 may include, for example, a motor, a piezoelectric element, or an electric stimulator.

The camera module 1480 may capture a still image or moving images. According to an embodiment, the camera module 1480 may include one or more lenses, image sensors, image signal processors, or flashes.

The power management module 1488 may manage power supplied to the electronic device 1401. According to one embodiment, the power management module 1488 may be implemented as at least part of, for example, a power management integrated circuit (PMIC).

The battery 1489 may supply power to at least one component of the electronic device 1401. According to an embodiment, the battery 1489 may include, for example, a primary cell which is not rechargeable, a secondary cell which is rechargeable, or a fuel cell.

The communication module 1490 may support establishing a direct (e.g., wired) communication channel or a wireless communication channel between the electronic device 1401 and the external electronic device (e.g., the electronic device 1402, the electronic device 1404, or the server 1408) and performing communication via the established communication channel. The communication module 1490 may include one or more communication processors that are operable independently from the processor 1420 (e.g., the application processor (AP)) and supports a direct (e.g., wired) communication or a wireless communication. According to an embodiment, the communication module 1490 may include a wireless communication module 1492 (e.g., a cellular communication module, a short-range wireless communication module, or a global navigation satellite system (GNSS) communication module) or a wired communication module 1494 (e.g., a local area network (LAN) communication module or a power line communication (PLC) module). A corresponding one of these communication modules may communicate with the external electronic device via the first network 1498 (e.g., a short-range communication network, such as BluetoothTM, wireless-fidelity (Wi-Fi) direct, or infrared data association (IrDA)) or the second network 1499 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1492 may identify and authenticate the electronic device 1401 in a communication network, such as the first network 1498 or the second network 1499, using subscriber information (e.g., international mobile subscriber identity (IMSI)) stored in the subscriber identification module 1496.

The wireless communication module 1492 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1492 may support a high-frequency band (e.g., the mmWave band) to achieve, e.g., a high data transmission rate. The wireless communication module 1492 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1492 may support various requirements specified in the electronic device 1401, an external electronic device (e.g., the electronic device 1404), or a network system (e.g., the second network 1499). According to an embodiment, the wireless communication module 1492 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1497 may transmit or receive a signal or power to or from the outside (e.g., the external electronic device) of the electronic device 1401. According to an embodiment, the antenna module 1497 may include an antenna including a radiating element composed of a conductive material or a conductive pattern formed in or on a substrate (e.g., a printed circuit board (PCB)). According to an embodiment, the antenna module 1497 may include a plurality of antennas (e.g., array antennas). In such a case, at least one antenna appropriate for a communication scheme used in the communication network, such as the first network 1498 or the second network 1499, may be selected, for example, by the communication module 1490 (e.g., the wireless communication module 1492) from the plurality of antennas. The signal or the power may then be transmitted or received between the communication module 1490 and the external electronic device via the selected at least one antenna. According to an embodiment, another component (e.g., a radio frequency integrated circuit (RFIC)) other than the radiating element may be additionally formed as part of the antenna module 1497.

According to various embodiments, the antenna module 1497 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1401 and the external electronic device 1404 via the server 1408 coupled with the second network 1499. Each of the electronic devices 1402 or 1404 may be a device of a same type as, or a different type, from the electronic device 1401. According to an embodiment, all or some of operations to be executed at the electronic device 1401 may be executed at one or more of the external electronic devices 1402, 1404, or 1408. For example, if the electronic device 1401 should perform a function or a service automatically, or in response to a request from a user or another device, the electronic device 1401, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1401. The electronic device 1401 may provide the outcome, with or without further processing of the outcome, as at least part of a reply to the request. To that end, a cloud computing, distributed computing, mobile edge computing (MEC), or client-server computing technology may be used, for example. The electronic device 1401 may provide ultra low-latency services using, e.g., distributed computing or mobile edge computing. In another embodiment, the external electronic device 1404 may include an internet-of-things (IoT) device. The server 1408 may be an intelligent server using machine learning and/or a neural network. According to an embodiment, the external electronic device 1404 or the server 1408 may be included in the second network 1499. The electronic device 1401 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1440) including one or more instructions that are stored in a storage medium (e.g., internal memory 1436 or external memory 1438) that is readable by a machine (e.g., the electronic device 1401). For example, a processor (e.g., the processor 1420) of the machine (e.g., the electronic device 1401) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

**Claims**

1. A wireless power receiver comprising:

   a resonance circuit comprising a coil having a plurality of turns and configured to receive power transmitted from a wireless power transmitter;
   an auxiliary reception coil inductively coupled to the coil and configured to establish a tap at a first point of the innermost turn among the plurality of turns of the coil to establish a loop comprising a part of the innermost turn of the coil; and
   a reception circuit unit electrically connected to the auxiliary reception coil and configured to process power induced into the auxiliary reception coil based on power received by the resonance circuit.

2. The wireless power receiver of claim 1, wherein a position of the first point is configured based on impedance matching with the wireless power transmitter transmitting power to the wireless power receiver.

3. The wireless power receiver of claim 2, wherein the position of the first point is configured based on characteristic resistance $R_e$ of the auxiliary reception coil.

4. The wireless power receiver of claim 3, wherein the characteristic resistance of the auxiliary reception coil is determined based on a coupling coefficient, a frequency, and an impedance of the auxiliary reception coil.

5. The wireless power receiver of claim 4, wherein the position of the first point is configured based on a value between 0.1 and 1 of the characteristic resistance $R_e$ of the auxiliary reception coil by an equation,

$$R_e = k^2 \omega L_{2a},$$

wherein k is a coupling coefficient, $\omega$ is an angular frequency, and $L_{2a}$ is an impedance of the receiving coil.

6. The wireless power receiver of claim 1, wherein the position of the first point is configured based on inductance of the coil and inductance of the auxiliary reception coil.

7. The wireless power receiver of claim 6, wherein the position of the first point is configured such that a ratio of the inductance of the auxiliary reception coil to the inductance of the coil is less than a configured value.

8. The wireless power receiver of claim 7, wherein the position of the first point is configured based on the number of the plurality of turns of the coil.

9. The wireless power receiver of claim 1, wherein the position of the first point is configured such that the inductance of the auxiliary reception coil is less than a configured value.

10. The wireless power receiver of claim 1, wherein the position of the first point is configured such that an interlinkage area configured by the coil and the auxiliary reception coil is less than a configured value.

11. The wireless power receiver of claim 1, wherein the auxiliary reception coil configures a first tap at the first point of the innermost turn among the plurality of turns of the coil and configures a second tap at a second point of the innermost turn among the plurality of turns of the coil.

12. The wireless power receiver of claim 11, wherein the auxiliary reception coil has a first auxiliary reception coil configured through a loop configured by the first tap and a second auxiliary reception coil configured through a loop configured by the second tap.

13. The wireless power receiver of claim 12, wherein the first auxiliary reception coil is connected to a first reception circuit unit and the second auxiliary reception coil is connected to a second reception circuit unit.

14. The wireless power receiver of claim 13, wherein power supplied to the first reception circuit unit is larger than power supplied to the second reception circuit unit.

15. A wireless power receiver comprising:

   a resonance circuit comprising a coil having a plurality of turns and configured to receive power transmitted from a wireless power transmitter; and
   an auxiliary reception coil inductively coupled to the coil and configured to establish a tap at a first point of the innermost turn among the plurality of turns of the coil to establish a loop comprising a part of the innermost turn of the coil.

FIG. 1A

111

Resonant coil L$_2$

121    M$_{2a}$

Receiver coil L$_{2a}$

C$_2$

~112

123    125

Rectifier    Load

## FIG. 1B

113    M$_{2a}$    122    100

R$_2$    R$_a$

101    V$_{ind}$    111    121    125    V$_L$

L$_2$    L$_{2a}$    R$_L$

112

## FIG. 1C

Voltage Gain $V_L / V_{ind}$

FIG. 2A

Output Power (W)

FIG. 2B

111

Resonant coil $L_2$

301

A

$C_2$

112

123

125

$L_2$

B

121

$M_{2a}$

302

Rectifier

Load

303

C

Receiver coil $L_{2a}$

$S_2$

FIG. 3

EP 4 262 051 A1

FIG. 4

Go

Return

Resonant coil L$_2$

S$_2$

Receiver coil L$_{2a}$

S$_{2a}$

D

Tap

501

# FIG. 5

FIG. 6

FIG. 7

FIG. 8

**111**

Resonant coil L$_2$

**901**

A

L$_2$

C$_2$ **112**

B

**902**

**123**

**125**

M$_{2a}$

**121**

Receiver coil L$_{2a}$

Rectifier    Load

Auxiliary source / sensor

**903**

C

S$_{2a}$

D

**904**

S$_2$

**911**   **912**

## FIG. 9

FIG. 10

111

Resonant coil L

1102

Go

1101

A

Tap

B

S$_{2a}$

Return

121

Receiver coil L$_{2a}$

S$_2$

FIG. 11

FIG. 12

FIG. 13A

FIG. 13B

FIG. 13C

FIG. 13D

P_out @ k = 0.2, R_L = 100Ω

FIG. 13E

P_out @ k = 0.3, R_L = 100Ω

FIG. 13F

FIG. 14

EP 4 262 051 A1

## INTERNATIONAL SEARCH REPORT

| International application No. |
|---|
| **PCT/KR2022/001593** |

**A. CLASSIFICATION OF SUBJECT MATTER**

**H02J 50/12**(2016.01)i; **H01F 38/14**(2006.01)i; **H03H 7/38**(2006.01)i; **H01F 5/02**(2006.01)i

According to International Patent Classification (IPC) or to both national classification and IPC

**B. FIELDS SEARCHED**

Minimum documentation searched (classification system followed by classification symbols)

H02J 50/12(2016.01); H01F 27/28(2006.01); H01F 38/14(2006.01); H01Q 1/52(2006.01); H01Q 7/00(2006.01); H02J 17/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 무선(wireless), 전력(power), 수신기(receiver), 보조 수신 코일(auxiliary receiving coil), 공진 회로(resonant circuit)

**C. DOCUMENTS CONSIDERED TO BE RELEVANT**

| Category* | Citation of document, with indication, where appropriate, of the relevant passages | Relevant to claim No. |
|---|---|---|
| A | US 2017-0236638 A1 (QUALCOMM INCORPORATED) 17 August 2017 (2017-08-17) See paragraphs [0042]-[0043]; and figure 3. | 1-15 |
| A | KR 10-2020-0115429 A (KOREA ELECTROTECHNOLOGY RESEARCH INSTITUTE) 07 October 2020 (2020-10-07) See paragraphs [0040]-[0047]; and figure 2. | 1-15 |
| A | KR 10-2019-0051035 A (LG ELECTRONICS INC.) 14 May 2019 (2019-05-14) See claims 1-14; and figure 12. | 1-15 |
| A | JP 2015-015852 A (EQUOS RESEARCH CO., LTD.) 22 January 2015 (2015-01-22) See claims 1-3; and figure 3. | 1-15 |
| A | US 2019-0097461 A1 (NUCURRENT, INC.) 28 March 2019 (2019-03-28) See claims 1-20; and figure 2. | 1-15 |

☐ Further documents are listed in the continuation of Box C.    ☑ See patent family annex.

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **13 May 2022** | **13 May 2022** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

INTERNATIONAL SEARCH REPORT
Information on patent family members

International application No.

**PCT/KR2022/001593**

| Patent document cited in search report | | | Publication date (day/month/year) | Patent family member(s) | | | Publication date (day/month/year) |
|---|---|---|---|---|---|---|---|
| US | 2017-0236638 | A1 | 17 August 2017 | WO | 2017-142686 | A1 | 24 August 2017 |
| KR | 10-2020-0115429 | A | 07 October 2020 | KR | 10-1497140 | B1 | 03 March 2015 |
| | | | | KR | 10-2015-0005479 | A | 14 January 2015 |
| | | | | KR | 10-2162859 | B1 | 20 October 2020 |
| | | | | US | 10141105 | B2 | 27 November 2018 |
| | | | | US | 2015-0302983 | A1 | 22 October 2015 |
| | | | | US | 2017-0352477 | A1 | 07 December 2017 |
| | | | | US | 9711278 | B2 | 18 July 2017 |
| | | | | WO | 2014-109460 | A1 | 17 July 2014 |
| KR | 10-2019-0051035 | A | 14 May 2019 | EP | 3525219 | A1 | 14 August 2019 |
| | | | | KR | 10-2209040 | B1 | 28 January 2021 |
| | | | | US | 11049648 | B2 | 29 June 2021 |
| | | | | US | 2020-0135391 | A1 | 30 April 2020 |
| | | | | WO | 2018-066789 | A1 | 12 April 2018 |
| JP | 2015-015852 | A | 22 January 2015 | | None | | |
| US | 2019-0097461 | A1 | 28 March 2019 | CN | 108140464 | A | 08 June 2018 |
| | | | | CN | 108140464 | B | 03 July 2020 |
| | | | | CN | 111681847 | A | 18 September 2020 |
| | | | | EP | 3332409 | A1 | 13 June 2018 |
| | | | | EP | 3332409 | A4 | 12 June 2019 |
| | | | | EP | 3657519 | A1 | 27 May 2020 |
| | | | | JP | 2018-533238 | A | 08 November 2018 |
| | | | | KR | 10-2018-0050279 | A | 14 May 2018 |
| | | | | US | 10063100 | B2 | 28 August 2018 |
| | | | | US | 10636563 | B2 | 28 April 2020 |
| | | | | US | 10658847 | B2 | 19 May 2020 |
| | | | | US | 11025070 | B2 | 01 June 2021 |
| | | | | US | 2017-0040695 | A1 | 09 February 2017 |
| | | | | US | 2017-0040696 | A1 | 09 February 2017 |
| | | | | US | 2020-0112176 | A1 | 09 April 2020 |
| | | | | US | 2020-0119565 | A1 | 16 April 2020 |
| | | | | US | 2020-0119590 | A1 | 16 April 2020 |
| | | | | US | 2021-0075109 | A1 | 11 March 2021 |
| | | | | US | 9960628 | B2 | 01 May 2018 |
| | | | | US | 9960629 | B2 | 01 May 2018 |
| | | | | WO | 2017-027326 | A1 | 16 February 2017 |

Form PCT/ISA/210 (patent family annex) (July 2019)